# EUROPEAN PATENT APPLICATION

(11) **EP 1 096 522 A2**
(43) Date of publication of application: **02.05.2001**
(21) Application number: 00123264.4
(22) Date of filing: 26.10.2000
(51) Int. Cl.: H01G 9/20

(54) **Photo-electrochemical cell comprising a molten salt electrolyte**

(30) Priority: 29.10.1999 JP 30958499
(71) Applicant: FUJI PHOTO FILM CO., LTD., Kanagawa 250-01 (JP)
(72) Inventor: Asami, Masahiro, Minami-Ashigara-shi, Kanagawa (JP); Ono, Michio, Minami-Ashigara-shi, Kanagawa (JP)
(74) Representative: Grünecker, Kinkeldey, Stockmair & Schwanhäusser Anwaltssozietät

(57) **Abstract**

A photoelectric conversion device comprising at least: a photosensitive layer comprising semiconductor particles; and a charge transporting layer, wherein the semiconductor particles comprise zinc oxide and tin oxide, and the charge transporting layer comprises a molten salt electrolyte.

## Description

### FIELD OF THE INVENTION

This invention relates to a photoelectric conversion device and a photo-electrochemical cell comprising the photoelectric conversion device. More particularly, it relates to a photoelectric conversion device using dye-sensitized semiconductor particles and a photo-electrochemical cell comprising the device which have a high short circuit current and a high photoelectric conversion.

### BACKGROUND OF THE INVENTION

In the field of photovoltaic power generation, the focus of research and development and practical application has been chiefly put on monocrystalline silicon solar cells, polycrystalline silicon solar cells, amorphous silicon solar cells, and compound solar cells using cadmium telluride, copper indium selenide, etc. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, *Nature*, vol. 353, pp. 737-740 (1991) and U.S. Patent 4,927,721 disclose a photoelectric conversion device using dye-sensitized semiconductor particles, a solar cell comprising the device, and materials and techniques for producing them. The proposed cell is a wet type solar cell comprising, as a work electrode, a porous thin film of titanium dioxide spectrally sensitized by a ruthenium complex. A primary advantage of this system is that such an inexpensive oxide semiconductor as titanium dioxide can be used without being highly purified so that a photoelectric conversion device can be supplied at a competitive price. A secondary advantage is that the sensitizing dye used shows a broad absorption spectrum so that substantially the whole range of visible light can be converted to electricity.

However, the materials disclosed are unsatisfactory from the standpoint of durability. Because the electrolyte used in the above-described wet system contains methoxyacetonitrile, acetonitrile, etc. that are low-molecular weight organic solvents, it has been difficult to maintain the performance stably for a long period of time under severe conditions of use, for example, in outdoor use due to leakage of the electrolyte or evaporation of the solvent.

In order to overcome this weak point, various techniques for improving durability by using a solidified electrolyte have been proposed to date. For instance, Tennakone et al. report in *Semicond. Sci. Technol*., vol. 10, p. 1689 (1995) a solid state solar cell in which CuI, which is a p-type semiconductor having no absorption in the visible region, is used in the electrolyte, the conversion efficiency of which is insufficient. Use of polypyrrole having a hole transporting ability (see Murakochi, *Chem*. *Lett*., p. 471 (1997)) and use of an arylamine (see U. Bach et al., *Nature*, vol. 395, p. 583 (1998)) have also been proposed, but the conversion efficiency of these materials are not sufficient, either.

Additionally, WO93/20565 discloses a photoelectric conversion device using a solid electrolyte, and *Nippon Kagaku Kaishi*, vol. 7, p. 484 (1986), JP-A-7-2881142, *Solid State Ionics*, vol. 89, p. 253 (1986), and JP-A-9-27352 disclose photoelectric conversion devices using a crosslinked polyethylene oxide-based polymer solid electrolyte, but none of them succeeds in achieving sufficient photoelectric conversion characteristics.

Another approach comprises using a molten salt, such as a pyridinium salt, art imidazolium salt or a triazonium salt, which is in a molten state at relatively low temperatures as a non-volatile electrolyte as reported in WO95/18456, JP-A-8-259543, and *Denki Kagaku*, vol. 65, No. 11, p. 923 (1997). These techniques are characterized by relatively satisfactory conversion efficiency as compared with the above-mentioned totally solidified cells.

However, the solar cells prepared by the inventors of the present invention by using these techniques have turned out to have various problems. That is, compared with solar cells comprising an electrolytic solution prepared by using an organic solvent, the solar cells containing the molten salt electrolyte have a lower short-circuit current. The reduction of the current is conspicuous when the working temperature decreases.

### SUMMARY OF THE INVENTION

An object of the present invention is to provide a photoelectric conversion device and a photo-electrochemical cell having high efficiency which have improved durability and a high short circuit current and undergoes little deterioration of performance even when the working temperature decreases.

The object of the invention has been accomplished by providing the following photoelectric conversion devices and photo-electrochemical cell.
(1) A photoelectric conversion device having a photosensitive layer comprising semiconductor particles and a charge transporting layer, wherein the semiconductor particles comprise zinc oxide and tin oxide, and the charge transporting layer comprises at least 50% by weight of a molten salt electrolyte.
(2) The photoelectric conversion device of item (1) above, wherein the semiconductor particles comprising zinc oxide and tin oxide are prepared by mixing zinc oxide particles and tin oxide particles and firing the mixture.
(3) The photoelectric conversion device of item (1) above, wherein the semiconductor particles comprising zinc oxide and tin oxide are prepared by mixing zinc oxide particles and tin chloride and firing the mixture.
(4) The photoelectric conversion device of item (1), (2) or (3) above, wherein the tin oxide is tin dioxide.
(5) The photoelectric conversion device of item (1), (2), (3) or (4) above, wherein the molten salt electrolyte comprises at least one compound selected from the group consisting of compounds represented by formula (Y-a), compounds represented by formula (Y-b), compounds represented by formula (Y-c): 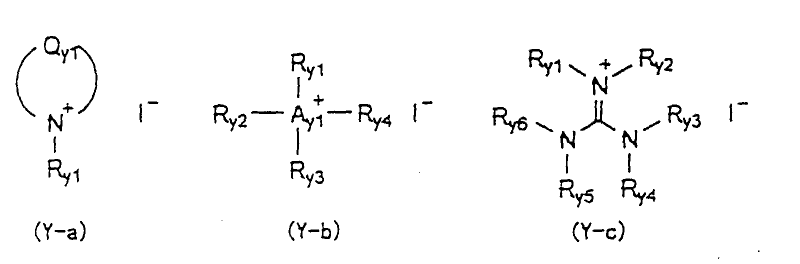 wherein Q_{y1} represents an atomic group capable of forming a 5- or 6-membered aromatic ring cation together with the nitrogen atom; A_{y1} represents a nitrogen atom or a phosphorus atom; R_{y1}, R_{y2}, R_{y3}, R_{y4}, R_{y5}, and R_{y6} each represent a substituted or unsubstituted alkyl group or a substituted or unsubstituted alkenyl group; two or more of R_{y1}, R_{y2}, R_{y3}, and R_{y4} in formula (Y-b) may be connected to each other to form a non-aromatic ring containing A_{y1}, and two or more of R_{y1}, R_{y2}, R_{y3}, R_{y4}, R_{y5}, and R_{y6} in formula (Y-c) may be connected to each other to form a cyclic structure; and the compound of formula (Y-a), (Y-b) or (Y-c) may have a polymerized form by linking through any of Q_{y1}, R_{y1}, R_{y2}, R_{y3}, R_{y4}, R_{y5}, and R_{y6}.
(6) The photoelectric conversion device of any of items (1) to (5) above, wherein the semiconductor particles have a dye adsorbed thereon.
(7) A photo-electrochemical cell comprising the photoelectric conversion device according to any one of items (1) to (6) above.

### BRIEF DESCRIPTION OF THE DRAWINGS

Fig. 1 is a schematic cross section of the photo-electrochemical cell prepared in Example.
Figs. 2A to 2D and 3E to 3G show basic structures of photo-electrochemical cells.
Fig. 4 shows an example of a substrate-integrated type module.

### DETAILED DESCRIPTION OF THE INVENTION

The photoelectric conversion device according to the invention comprises an electrically conductive support, a semiconductor layer sensitized with a dye, etc. (photosensitive layer) provided on the conductive support, a charge transporting layer, arid a counter electrode. The photo-electrochemical cell according to the invention is a practical application of the photoelectric conversion device for use as a battery working in an external circuit.

The photosensitive layer is designed to fit for the end use and can have either a single layer structure or a multilayer structure. Light having entered the photosensitive layer excites the dye, etc. The excited dye, etc. have high energy electrons, which are handed over from the dye, etc. to the conduction band of the semiconductor particles and diffused to reach the conductive support. Oxidized molecules of the dye, etc. which result from the electron migration are regenerated by the electrons supplied from the counter electrode and the charge transporting layer. The semiconductor layer acts as a negative electrode of the cell. The components of the individual layers constituting the device may be diffused and mixed mutually at their boundaries, for example, the boundary between the conductive layer (hereinafter described) of the conductive support and the photosensitive layer, the boundary between the photosensitive layer and the charge transporting layer, and the boundary between the charge transporting layer and the counter electrode.

The semiconductor layer for use in the present invention comprises at least zinc oxide and tin oxide, which are preferably semiconductor particles. The tin oxide is preferably tin dioxide.

The size of the oxide particles constituting the semiconductor porous film is selected appropriately so as to form a porous electrode with a sufficient surface area. A preferred particle size of zinc oxide is, but is not limited to, 5 nm to 1000 nm, particularly 10 to 500 nm. A preferred particle size of tin oxide is, while not being limited to, 1 to 500 nm, particularly 2 to 200 nm.

The amount ratio of the zinc oxide to the tin oxide depends on and varies according to a desired degree of improvement on photoelectric conversion efficiency. It preferably ranges from 10:90 to 90:10, particularly 30 to 70 to 70:30, by weight.

A semiconductor porous film comprising zinc oxide and tin oxide can be formed by various methods. For example, the method described in K. Tennakone, *Chem. Commun*., pp. 15-16 (1999) can be followed. That is, 0.1 ml of acetic acid and 0.3 g of zinc oxide particles having a grain size of about 2 µm which are prepared by pyrolysis of zinc oxalate are added to 1.5 ml of a 15% aqueous dispersion of colloidal tin oxide particles having a grain size of about 0.015 µm. The mixture is mixed in an agate mortar, and 20 ml of methanol is added thereto, followed by ultrasonic dispersion for 30 minutes. The resulting suspension is sprayed on a glass substrate having a fluorine-doped tin oxide film heated to 150°C to a coating thickness of 8 to 10 µm and fired at 500°C in air for 35 minutes to prepare a semiconductor porous electrode.

The methods disclosed in K. Tennakone, *J. Phys. D: Appl. Phys*., vol. 32, pp. 374-379 (1999) can also be used. According to the first method disclosed, 0.4 g of zinc oxide having an average particle size of 0.55 µm or smaller and 1.4 g of stannous chloride are mixed with 0.5 ml of water, and 0.3 ml of nitric acid and 2 ml of ethanol are added. The mixture is thoroughly mixed in an agate mortar, and the resulting paste is spread on a conductive glass substrate having a fluorine-doped tin oxide film. After drying at 150°C for 3 minutes, the coating film is fired at 500°C for 4 to 6 minutes. After allowing the coated substrate to cool to room temperature, the surface oxide particles that are not fixed are removed, and the same operation is repeated until a coating layer of about 6 µm is built up to obtain a semiconductor porous electrode. According to the second method disclosed, 0.6 g of zinc oxide having an average particle size of 1.5 µm or smaller and 0.6 g of stannous chloride are mixed with 3 ml of water and 5 ml of methanol, and the mixture is thoroughly mixed in an agate mortar. To the mixture is further added 10 ml of methanol, followed by dispersion by ultrasonication. The resulting suspension is sprayed on a conductive glass substrate having a fluorine-doped tin oxide film heated to 150°C to a coating thickness of 8 to 10 µm and burned at 500°C in air for 40 minutes to obtain a semiconductor porous electrode.

Other various methods can be used in addition to the above-mentioned methods. Hydrothermal synthesis from a metal hydroxide obtained by hydrolysis of a metal halide or alkoxide is a preferred example. Hydrothermal synthesis can be embodied by a sol-gel process comprising heating a colloidal metal hydroxide dispersion, which is obtained by hydrolysis of a metal halide or alkoxide, in an autoclave at 80 to 250°C to form fine oxide particles and a gel-sol process in which a metal hydroxide having formed a gel network is similarly heated in an autoclave to form fine oxide particles. In carrying out the latter process, it is a preferred embodiment that a metal chloride or alkoxide is previously allowed to react with a compound capable of forming a complex with metal to form a stable complex, which is then hydrolyzed into a hydroxid gel.

The ligand which constitutes the metal complex preferably includes compounds having a hydroxyl group, a carbonyl group, an ester group or a carboxyl group and amine compounds. The ligand may be unidentate, bidentate or tridentate. Multidentate ligands are preferred for forming a stable complex. Polynuclear ligand compounds are also employable.

The compounds having a hydroxyl group include alkanolamine compounds, polyol compounds, glycol compounds, oxycarboxylic acids, and polyhydric phenols. The compounds having a carbonyl group include β-diketone compounds, β-keto ester compounds, oxime compounds, dioxime compounds, and urea compounds. The compounds having art ester group include β-keto ester compounds. The compounds having a carboxyl group include polycarboxylic acids, oxycarboxylic acids, amino acids, and nitrogen-containing carboxylic acids. The amine compounds include alkanolamines and diamines. Preferred of these ligand compounds are alkanolamine compounds, glycol compounds, oxycarboxylic acids, β-diketone compounds, β-keto ester compounds, and diamine compounds. Examples of the preferred compounds are diethanolamine, triethanolamine, trimethylolamine, pentaerythritol, trimethylolethane, trimethylolpropane, ethylenediamine, acetylacetone, succinic acid, phthalic acid, citric acid, tartaric acid, malic acid, glycolic acid, methyl acetoacetate, ethylene glycol, hexylene glycol, dimethyl glyoxime, and picolic acid. Triethanolamine is particularly preferred.

Various other semiconductors can be used in combination with the above-mentioned zinc oxide and tin oxide. Useful semiconductors include compound semiconductors represented by metal chalcogenides (e.g., oxides, sulfides, selenides, etc.) and compounds having a perovskite structure. The metal chalcogenides preferably include an oxide of titanium, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. Other compound semiconductors include a phosphide of zinc, gallium, indium or cadmium, gallium arsenide, copper indium selenide, and copper indium sulfide. The perovskite semiconductors include strontium titanate, calcium titanate, sodium titanate, barium titanate, and potassium niobate.

Specific examples of semiconductors preferred for combined use include TiO₂, Fe₂O₃, WO₃, Nb₂O₅, CdS, ZnS, PbS, Bi₂S₃, CdSe, CdTe, CuInS₂, and CuInSe₂.

The semiconductor particles which can be used in the present invention may be amorphous, single crystalline or polycrystalline. Microfine particles on the order of nanometer to micron meter are preferred. The particle size can be expressed in terms of a projected area diameter (the diameter of a circle having the same area of the projected area of the particle), which is obtained, for precision, from the projected area of a micrograph under a transmission electron microscope. Where the particles are crystals, an average primary particle size can be obtained, for convenience, from the line width of X-ray diffraction in accordance with the Scherrer's formula. The particulate semiconductors preferably have an average primary particle size of 5 to 200 nm, particularly 8 to 100 nm, with a coefficient of variation (a ratio of a standard deviation of the particle size to a mean particle size, usually represented by percentages) of 50% or less, particularly 30% or less, especially 20% or less. The semiconductor particles in a dispersed state (secondary particles) preferably have an average particle size of 0.01 to 100 µm.

Semiconductor particles of two or more kinds different in size distribution can be used as a mixture. In this case, the average size of smaller particles is preferably 10 nm or less. For the purpose of scattering incident light to improve the rate of capturing light, large semiconductor particles about 300 nm or greater in size may be used in combination.

The electrically conductive support on which the semiconductor porous film is supported includes a substrate made of a conductive material, such as metal, and a nonconductive substrate made of glass or plastics having thereon a conductive layer. Preferred conductors for use in the latter type of conductive substrates include metals (e.g., platinum, gold, silver, copper, aluminum, rhodium, and indium), carbon, and electrically conductive metal oxides (e.g., indium tin oxide and fluorine-doped tin oxide). The conductive layer preferably has a thickness of about 0.02 to 10 µm.

The conductive support preferably has as low a surface resistance as possible. A desirable surface resistance is 100 Ω/square or smaller, particularly 40 Ω/square or smaller. While not limiting, the practical minimal surface resistance is about 0.1 Ω/square.

It is preferred that the conductive support be substantially transparent to light. The term "substantially transparent" is intended to mean that the light transmission is at least 10%, preferably 50% or more, still preferably 70% or more. A transparent substrate such as glass or plastic, having a conductive metal oxide layer coated thereon is preferred as a transparent support. Of the above conductive supports particularly preferred is a conductive glass support obtained by depositing a conductive layer comprising fluorine-doped tin dioxide on a transparent substrate made of inexpensive soda-lime float glass. For the manufacture of inexpensive flexible photoelectric conversion devices or solar cells, a support comprising a transparent polymer film having the above-described conductive layer is suitable. Useful transparent polymers include tetraacetylcellulose (TAC), polyethylene terephthalate (PET), polyethylene naphthalate (PEN), syndiotactic polystyrene (SPS), polyphenylene sulfide (PPS), polycarbonate (PC), polyacrylate (PAr), polysulfone (PSF), polyester sulfone (PES), polyether-imide (PEI), cyclic polyolefins, and brominated phenoxy resins. The coated amount of the conductive metal oxide is preferably 0.01 to 100 g per m² of a glass or plastic substrate. The transparent conductive support is preferably used in such a manner that incident light enters from the support (substrate) side.

In order to decrease the resistance of the transparent conductive support, it is preferred to use metal leads, which are preferably made of aluminum, copper, silver, gold, platinum, nickel, etc., with an aluminum lead or a silver lead being particularly preferred. The metal lead is preferably formed on the transparent substrate by vacuum evaporation, sputtering or a like deposition technique, on which a transparent conductive layer of fluorine-doped tin oxide or ITO is provided. It is also preferred that the transparent conductive layer be provided on the transparent substrate, on which the metal lead can be formed. Reduction in incident light quantity due to the metal leads is usually 1 to 10%, preferably 1 to 5%.

The semiconductor particles are applied to the conductive support by, for example, a method comprising coating the conductive support with a dispersion or colloidal solution of the semiconductor particles. Film formation in a wet system is relatively advantageous, taking into consideration suitability to large-scale production of a photoelectric conversion device, controllability of liquid physical properties, and adaptability to various substrates. Film formation in a wet system is typically carried out by coating or printing.

Useful dispersing media include water and various organic solvents, such as methanol, ethanol, isopropyl alcohol, dichloromethane, acetone, acetonitrile, and ethyl acetate. In preparing a dispersion, a polymer (e.g., polyethylene glycol), a surface active agent, an acid, a chelating agent, and the like may be added as a dispersant if desired. In particular, use of polyethylene glycol with an appropriately controlled molecular weight is effective for forming a hardly peelable film or for modifying the viscosity of the dispersion.

Wet coating techniques include application methods such as roll coating and dip coating, metering methods such as air knife coating or blade coating, and application methods combined with metering such as wire bar coating (JP-B-58-4589), slide hopper coating (U.S. Patents 2,681,294, 2,761,419, and 2,761,791), extrusion coating, and curtain coating. General-purpose spin coating or spraying techniques are also suitable. Wet printing techniques include letterpress printing, offset printing, gravure printing, intaglio printing, rubber plate printing, and screen printing. A suitable film formation system is chosen from among the above-enumerated techniques in accordance with the liquid viscosity and a desired wet thickness.

The liquid viscosity is largely dependent on the kind and the dispersibility of the semiconductor particles, the solvent, and additives, such as a surface active agent and a binder. In order to form a uniform film, extrusion coating or casting is fit for a high viscous liquid (e.g., 0.01 to 500 Poise), while slide hopper coating, wire bar coating or spin coating is suited for a low viscous liquid (e.g., 0.1 Poise or lower). A low viscous liquid could be applied by extrusion coating where it is to be applied to some coating weight. Screen printing, as is often used in applying a high-viscosity paste of semiconductor particles, can be used as well. Thus, a suitable wet process for film formation can be selected in accordance with such parameters as the liquid viscosity, the coating weight, the type of the support, the speed of application, and so forth.

The semiconductor layer does not need to be a single layer. Two or more layers different in particle size of semiconductor particles, in kind of semiconductors or in composition as for the binder or additives can be provided. In case where single operation of application is insufficient for giving a desired thickness, multilayer coating is effective. Extrusion coating or slide hopper coating is suitable for multilayer coating. Multilayer coating can be carried out simultaneously or by successively repeating the coating operation several times or more than ten times. Screen printing is also preferably applicable to successive multilayer coating.

If desired, an undercoat can be provided between the conductive support and the particulate semiconductor layer for preventing a shot circuit or other purposes. A layer denser than the particulate semiconductor layer, such as a metal oxide (e.g., titanium oxide or zinc oxide) layer, is suitable as an undercoat.

In general, as the thickness of the particulate semiconductor layer increases, the amount of the dye held per unit projected area increases to show an increased rate of capturing light, but the distance of diffusion of generated electrons also increases, which results in an increased loss due to re-coupling of charges. Accordingly, there is a favorable thickness range for the particulate semiconductor layer, which is typically from 0.1 to 100 µm. Where the device is used as a photo-electrochemical cell, a favorable thickness is 1 to 30 µm, particularly 2 to 25 µm. The coating weight of the semiconductor particles is preferably 0.5 to 400 g/m², still preferably 5 to 100 g/m².

It is preferred that the semiconductor particles applied to the support be heated to bring them into electronic contact with each other, to improve film strength, and to improve adhesion to the support. A preferred heating temperature is 40°C or higher and lower than 700°C, particularly from 100 to 600°C. The heating time is usually from about 10 minutes to about 10 hours. Where a substrate having a low melting point or a low softening point, such as a polymer film, is used, high-temperature treatment which would deteriorate the substrate should be avoided. For the economical consideration, too, the heating temperature is preferably as low as possible. The heating temperature could be lowered by using small semiconductor particles having a diameter of up to 5 nm in combination or by conducting the heat treatment in the presence of a mineral acid.

For the purpose of increasing the surface area of the semiconductor particles and of increasing the purity in the vicinities of the semiconductor particles thereby to improve electron injection efficiency from the dye to the semiconductor particles, the heat-treated particulate semiconductor layer can be subjected to chemical plating with a titanium tetrachloride aqueous solution or electrochemical plating with a titanium trichloride aqueous solution.

It is preferable for the semiconductor particles to have a large surface area so that they may adsorb as large an amount of a dye as possible. The surface area of the semiconductor particles in the state applied to the conductive support is preferably 10 times or more, still preferably 100 times or more, the projected area. The practical upper limit of the surface area is, but is not limited to, about 1000 times the projected area.

The dye which can be used in the present invention includes complex dyes (particularly metal complex dyes) and methine dyes. Two or more kinds of dyes can be used in combination so as to broaden the wavelength region of photoelectric conversion and to increase the conversion efficiency. The dyes to be combined and their ratio can be selected in conformity with the wavelength region and the intensity distribution of a light source to be used. It is preferred for the dyes to have an appropriate interlocking group for linking to the surface of the semiconductor particles. Preferred interlocking groups include -OH, -COOH, -SO₃H, a cyano group, -P(O)(OH)₂, -OP(O)(OH)₂, and chelating groups having π conductivity, such as oxime, dioxime, hydroxyquinoline, salicylate and α-keto-enolate groups. Particularly preferred of them are -COOH, -P(O)(OH)₂, and -OP(O)(OH)₂. The interlocking group may be in the form of a salt with an alkali metal, etc. or an intramolecular salt. Where the methine chain of a polymethine dye has an acidic group as in the case where the methine chain forms a squarylium ring or a croconium ring, that moiety can serve as a interlocking group.

The metal complex dyes preferably include ruthenium complex dyes. Useful ruthenium complex dyes are described, e.g., in U.S. Patents 4,927,721, 4,684,537, 5,084,365, 5,350,644, 5,463,057, and 5,525,440, JP-A-7-249790, JP-W-10-504521, and WO98/50393. Those represented by formula (I) are particularly preferred.

(Aₗ)ₚRuBₐB_{b}B_{c} (I)

wherein Aₗ represents a ligand selected from Cl, SCN, H₂O, Br, I, CN, NCO and SeCN; p represents an integer of 0 to 2, preferably 2; and Bₐ, B_{b}, and B_{c} each represent an organic ligand selected from B-1 to B-8 shown below. 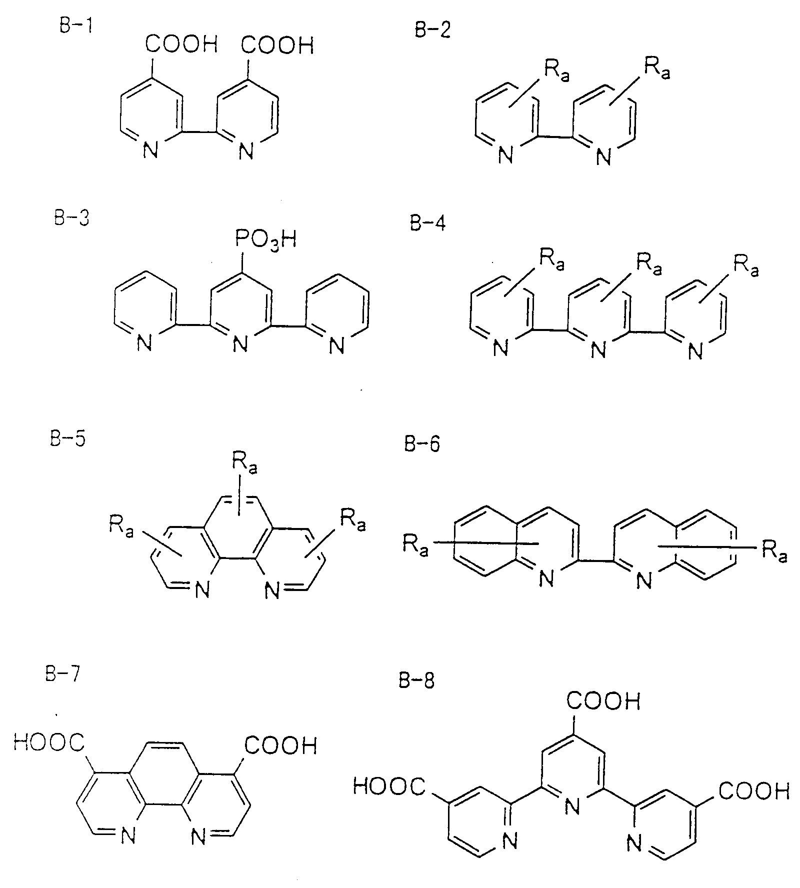 wherein Rₐ represents a hydrogen atom, halogen atom, a substituted or unsubstituted alkyl group having 1 to 12 carbon atoms, a substituted or unsubstituted aralkyl group having 7 to 12 carbon atoms, or a substituted or unsubstituted aryl group having 6 to 12 carbon atoms. The alkyl group and the alkyl moiety of the aralkyl group may be either straight or branched, and the aryl group and the aryl moiety of the aralkyl group may be either monocyclic or polycyclic (condensed rings or independent rings).

Specific examples of preferred ruthenium complex dyes represented by formula (I) are tabulated below.

| (Aₗ)ₚRuBₐB_{b}B_{c} | | | | | | |
|---|---|---|---|---|---|---|
| No. | Aₗ | p | Bₐ | B_{b} | B_{c} | Rₐ |
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN | 1 | B-8 | B-2 | - | H |
| R-13 | - | 0 | B-1 | B-1 | B-1 | - |

Specific examples of other preferred metal complex dyes are shown below.

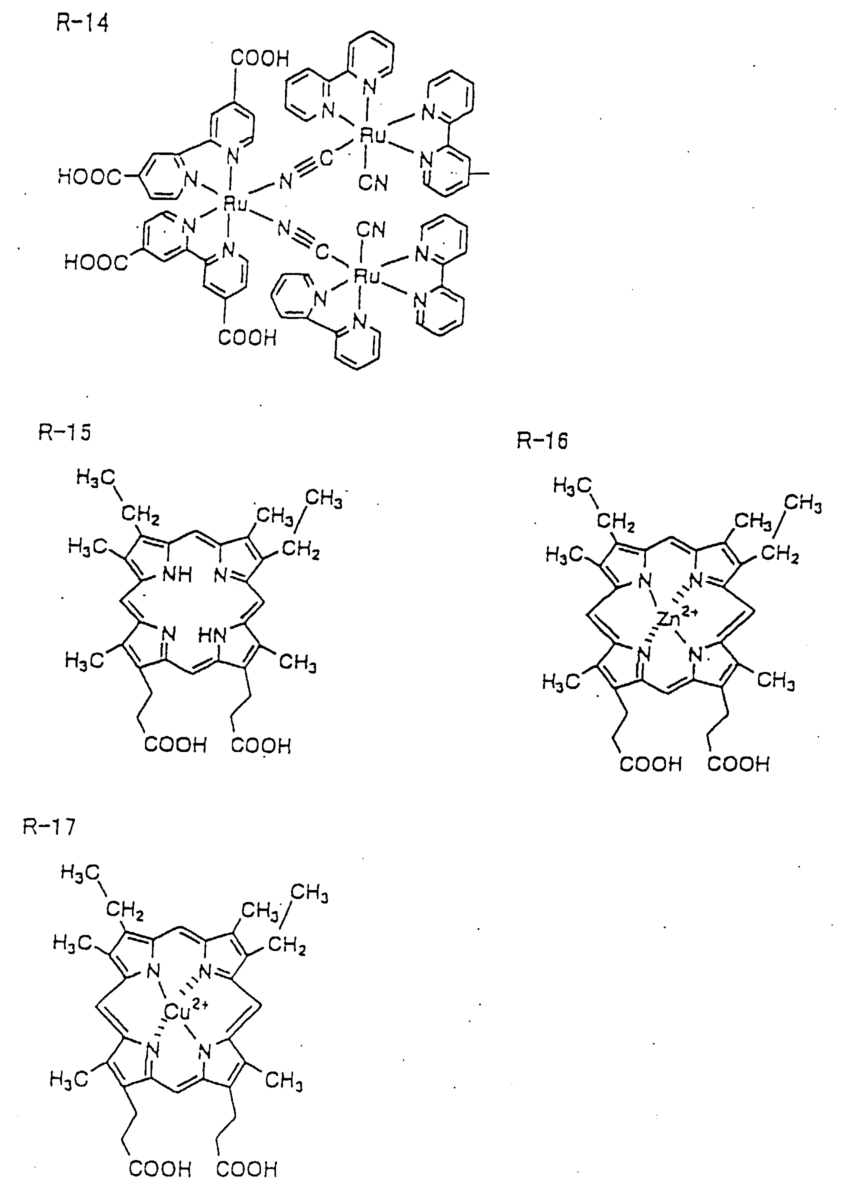

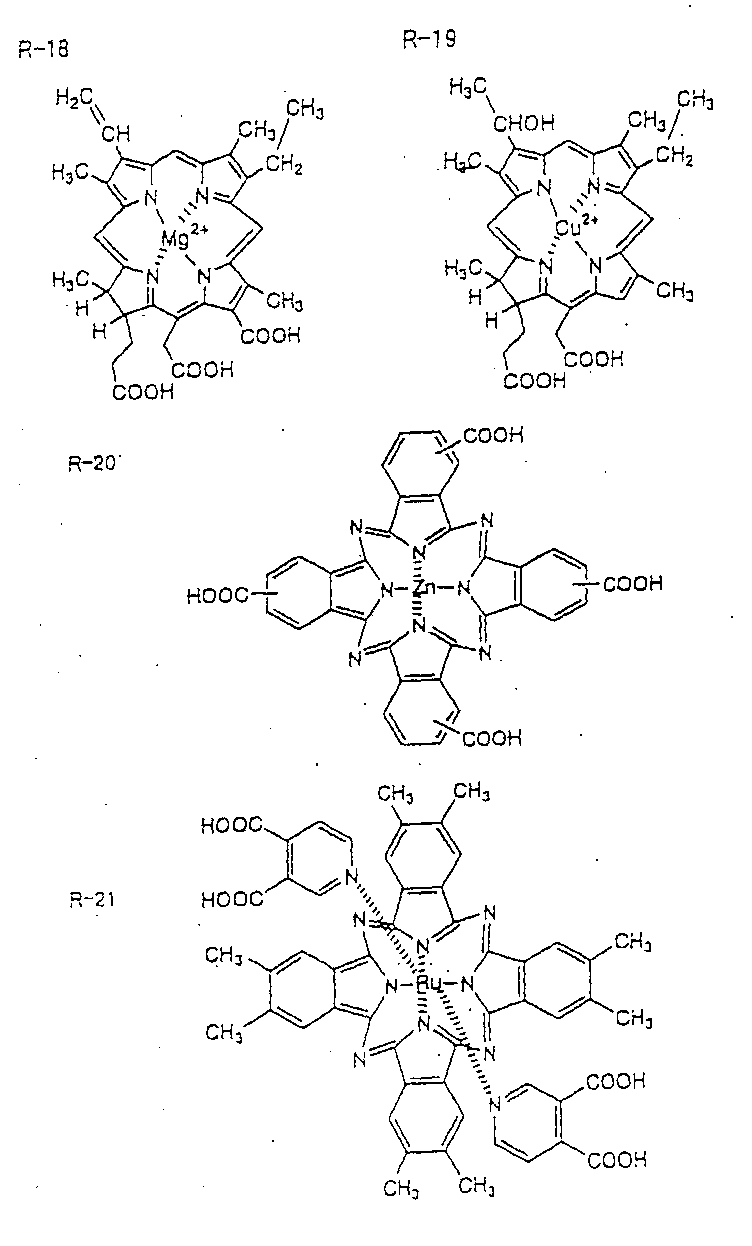

The methine dyes which can be used preferably include those described in JP-A-11-35836, JP-A-11-158395, JP-A-11-163378, JP-A-11-214730, JP-A-11-214731, EP 892411, and EP 911841. These methine dyes are synthesized with reference to the teachings of F.M. Hamer, *Heterocyclic Compounds-Cyanine Dyes and Related Compounds*, John Wiley & Sons (1964), D.M. Sturmer, *Heterocyclic Compounds-Special Topics in Heterocyclic Chemistry*, ch. 18, §14, pp. 482-515, John Wiley & Sons (1977), and *Rodd's Chemistry of Carbon Compounds*, 2nd Ed., vol. IV, part B, ch. 15, pp. 369-422, Elsevier Science Publishing Company Inc., GB Patent 1,077,611, *Ukrainskii Khimicheskii Zhurnal*, vol. 40, No. 3, pp. 253-258, *Dyes and Pigment*, vol. 21, pp. 227-234, and references cited therein.

Adsorption of the dyes onto semiconductor particles is effected by dipping a well-dried work electrode having semiconductor particles in a dye solution (which can be embodied by immersion, dip coating, roll coating, air knife coating, etc.) or coating the semiconductor layer with a dye solution (which can be embodied by wire bar coating, slide hopper coating, extrusion coating, curtain coating, spin coating, spraying, letterpress printing, offset printing, gravure printing, screen printing, etc.). In case of immersion, the dye adsorption may be either at room temperature or under reflux as taught in JP-A-7-249790.

The solvent of the dye solution is selected appropriately according to the solubility of the dye. Solvents of choice include water, alcohols (e.g., methanol, ethanol, t-butanol and benzyl alcohol), nitriles (e.g., acetonitrile, propionitrile and 3-methoxypropionitrile), nitromethane, halogenated hydrocarbons (e.g., dichloromethane, dichloroethane, chloroform, and chlorobenzene), ethers (e.g., diethyl ether and tetrahydrofuran), dimethyl sulfoxide, amides (e.g., N,N-dimethylformamide and N,N-dimethylacetamide), N-methylpyrrolidone, 1,3-dimethylimidazolidinone, 3-methyloxazolidinone, esters (e.g., ethyl acetate and butyl acetate), carbonic esters (e.g., diethyl carbonate, ethylene carbonate, and propylene carbonate), ketones (e.g., acetone, 2-butanone, and cyclohexanone), hydrocarbons (e.g., hexane, petroleum ether, benzene, and toluene), and mixtures thereof.

As previously mentioned with regard to the formation of the particulate semiconductor layer, extrusion coating and various printing methods are fit for a high viscous dye solution (e.g., 0.01 to 500 Poise), while slide hopper coating, wire bar coating and spin coating are suited for a low viscous dye solution (e.g., 0.1 Poise or lower) to form a uniform film. In this way, an appropriate technique for dye adsorption is to be selected according to such parameters as the viscosity of the dye solution, the coating weight, the kind of the substrate, the speed of application, and the like. Taking the suitability to large-scale production, the time required for dye adsorption after dye application is conveniently as short as possible.

In order to obtain a sufficient sensitizing effect, the dyes are preferably adsorbed in a total amount of 0.01 to 100 mmol per m² of the substrate and 0.01 to 1 mmol per gram of the semiconductor particles. With too small a total amount of the dyes, the sensitizing effect would be insufficient. If the dyes are used in too large a total amount, the non-adsorbed dyes will float only to lessen the sensitizing effect.

The above-described heat treatment of the semiconductor layer before dye adsorption is favorable for increasing the amount of the dyes adsorbed. Where the heat treatment is conducted, it is preferred that the dyes be quickly adsorbed into the heated semiconductor layer while it is between 40°C and 80°C so as to prevent water from being adsorbed to the semiconductor particles.

A colorless compound may be adsorbed together with the dyes so as to lessen the interaction among dye molecules, such as association. Hydrophobic compounds such as carboxyl-containing steroid compounds (e.g., chenodeoxycholic acid) can be used for this purpose. Ultraviolet absorbers may be adsorbed in combination to prevent deterioration by ultraviolet light.

Because dyes remaining unadsorbed cause disturbances of device performance, they should be washed away immediately after adsorption. Washing is conveniently carried out in a wet washing tank with an organic solvent, such as a polar solvent (e.g., acetonitrile) or an alcohol. If desired, the surface of the semiconductor particles can be treated with an amine after dye adsorption so as to accelerate removal of the unadsorbed dyes. Preferred amines include pyridine, 4-t-butylpyridine, and polyvinylpyridine. The amine can be used as such where it is liquid, or as dissolved in an organic solvent.

The charge transporting layer is a layer for replenishing the light-excited, i.e., oxidized dyes with electrons. Charge transporting layers which have been proposed or in general use, in the art include those comprising a solution of a redox pair in an organic solvent (i.e., an electrolytic solution), a gel electrolyte comprising a polymer matrix gel impregnated with an electrolytic solution, a molten salt containing a redox pair, a solid electrolyte, and a hole-transporting material. The present invention is characterized in that the charge transporting layer comprises a molten salt electrolyte. The term "molten salt electrolyte" means an electrolyte comprising a salt which is liquid at relatively low temperatures, such as a pyridinium salt, an imidazolium salt and a triazonium salt. Useful molten salt electrolytes are described, e.g., in WO95/18456, JP-A-8-259543, and *Denki Kagaku*, vol. 65, No. 11, p. 923 (1997).

Of these known molten salts preferred are those having a molten state at 200°C or lower temperatures, particularly 150°C or lower temperatures. Those which get into a molten state near room temperature (60°C or lower) are called room temperature molten salts, which are favorable for increasing the efficiency at room temperature.

Preferred molten salts include those represented by the following formulae (Y-a), (Y-b), and (Y-c):

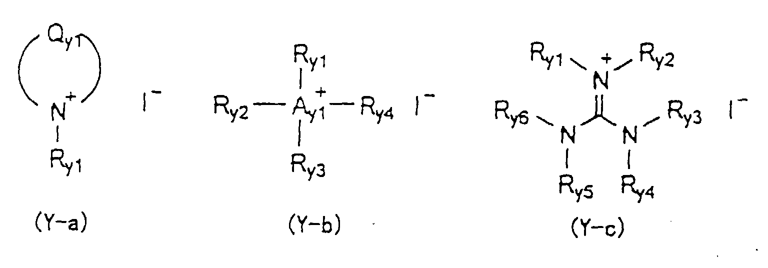

In formula (Y-a), Q_{y1} represents an atomic group forming a 5- or 6-membered aromatic ring cation together with the nitrogen atom. Q_{y1} is preferably made up of atoms selected from carbon, hydrogen, nitrogen, oxygen, and sulfur. The 5-membered ring completed by Q_{y1} is preferably an oxazole ring, a thiazole ring, an imidazole ring, a pyrazole ring, an isoxazole ring, a thiadiazole ring, an oxadiazole ring or a triazole ring, still preferably an oxazole ring, a thiazole ring or an imidazole ring, particularly preferably an oxazole ring or an imidazole ring. The 6-membered ring completed by Q_{y1} is preferably a pyridine ring, a pyrimidine ring, a pyridazine ring, a pyrazine ring or a triazine ring, with a pyridine ring being still preferred.

In formula (Y-b), A_{y1} represents a nitrogen atom or a phosphorus atom.

In formulae (Y-a), (Y-b) and (Y-c), R_{y1}, R_{y2}, R_{y3}, R_{y4}, R_{y5} and R_{y6} each represent a substituted or unsubstituted alkyl group (preferably a straight-chain, branched or cyclic alkyl group having 1 to 24 carbon atoms, such as methyl, ethyl, propyl, isopropyl, pentyl, hexyl, octyl, 2-ethylhexyl, t-octyl, decyl, dodecyl, tetradecyl, 2-hexyldecyl, octadecyl, cyclohexyl, or cyclopentyl) or a substituted or unsubstituted alkenyl group (preferably a straight-chain or branched alkenyl group having 2 to 24 carbon atoms, such as vinyl or allyl). R_{y1}, R_{y2}, R_{y3}, R_{y4}, R_{y5}, and R_{y6} each preferably represent an alkyl group having 2 to 18 carbon atoms or an alkenyl group having 2 to 18 carbon atoms, particularly an alkyl group having 2 to 6 carbon atoms.

In formula (Y-b), two or more of R_{y1}, R_{y2}, R_{y3}, and R_{y4} may be taken together to form a non-aromatic ring containing A_{y1}. In formula (Y-c), two or more of R_{y1}, R_{y2}, R_{y3}, R_{y4}, R_{y5}, and R_{y6} may be taken together to form a cyclic structure.

In formulae (Y-a), (Y-b), and (Y-c), Q_{y1}, R_{y1}, R_{y2}, R_{y3}, R_{y4}, R_{y5}, and R_{y6} may have a substituent. Suitable substituents include a halogen atom (e.g., F, Cl, Br or I), a cyano group, an alkoxy group (e.g., methoxy or ethoxy), an aryloxy group (e.g., phenoxy), an alkylthio group (e.g., methylthio or ethylthio), an alkoxycarbonyl group (ethoxycarbonyl), a carbonic ester group (e.g., ethoxycarbonyloxy), an acyl group (e.g., acetyl, propionyl or benzoyl), a sulfonyl group (e.g., methanesulfonyl or benzenesulfonyl), an acyloxy group (e.g., acetoxy or benzoyloxy), a sulfonyloxy group (e.g., methanesulfonyloxy or toluenesulfonyloxy), a phosphonyl group (e.g., diethylphosphonyl), an amido group (e.g., acetylamino or benzoylamino), a carbamoyl group (e.g., N,N-dimethylcarbamoyl), an alkyl group (methyl, ethyl, propyl, isopropyl, cyclopropyl, butyl, 2-carboxyethyl or benzyl), an aryl group (e.g., phenyl or toluyl), a heterocyclic group (e.g., pyridyl, imidazolyl or furanyl), and an alkenyl group (e.g., vinyl or 1-propenyl).

The compounds represented by formulae (Y-a), (Y-b) or (Y-c) may form polymers at Q_{y1}, R_{y1}, R_{y2}, R_{y3}, R_{y4}, R_{y5} or R_{y6}.

These molten salts may be used either individually or as a mixture of two or more thereof or in combination with other molten salts of the above-described structures in which the iodide anion is replaced with other anions, preferably other halide ions (e.g., Cl⁻ and Br⁻), NSC⁻, BF₄⁻, PF₆⁻, ClO₄⁻, (CF₃SO₂)₂N⁻, (CF₃CF₂SO₂)₂N⁻, CF₃SO₃⁻, CF₃COO⁻, Ph₄B⁻, or (CF₃SO₂)₃C⁻, particularly (CF₃SO₂)₂N⁻ or BF₄⁻. Other iodine salts, such as LiI, can also be added.

While the molten salt is preferably used without the use of the solvent, it is possible to use the molten salt with the solvent hereinafter described. It is preferred that the molten salt be present in an amount of at least 50% by weight, more preferably at least 70% by weight, based on the total electrolyte composition. It is also preferred that 50% by weight or more, particularly 70% or more, of the molten salt be the iodine salt.

It is preferable to add iodine to the electrolyte composition. The content of iodine, if added, is preferably 0.1 to 20% by weight, still preferably 0.5 to 5% by weight, based on the total electrolyte composition

Specific examples of molten salts which are preferably used in the invention are shown below for illustrative purposes only but not for limitation.

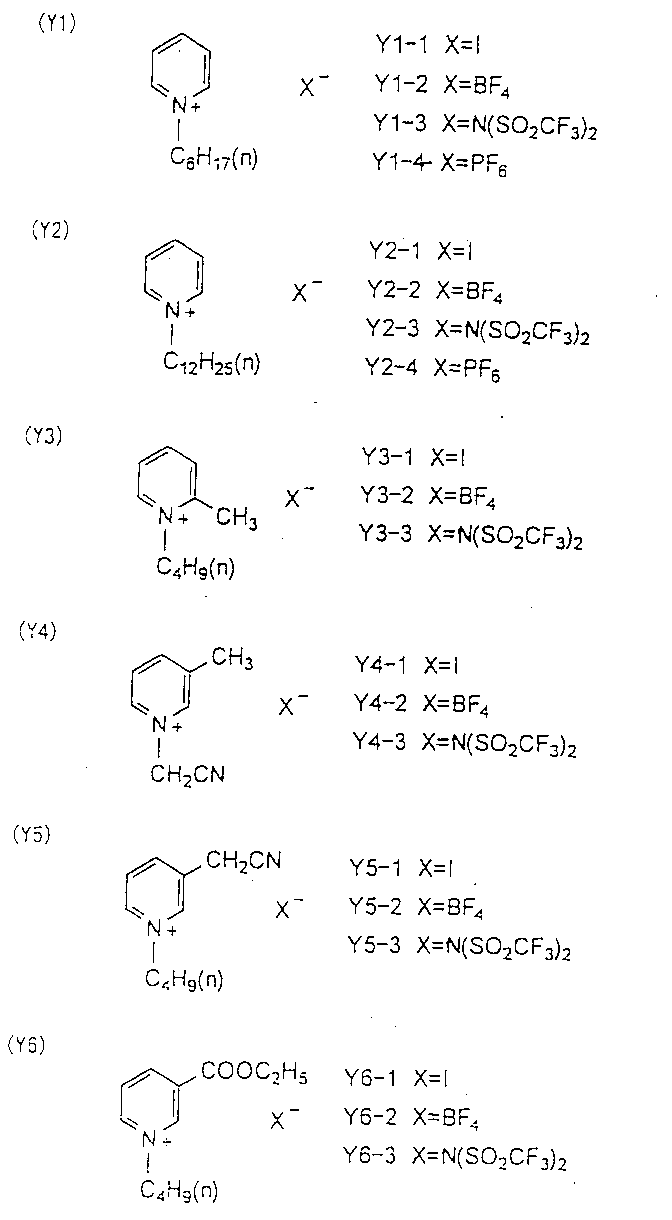

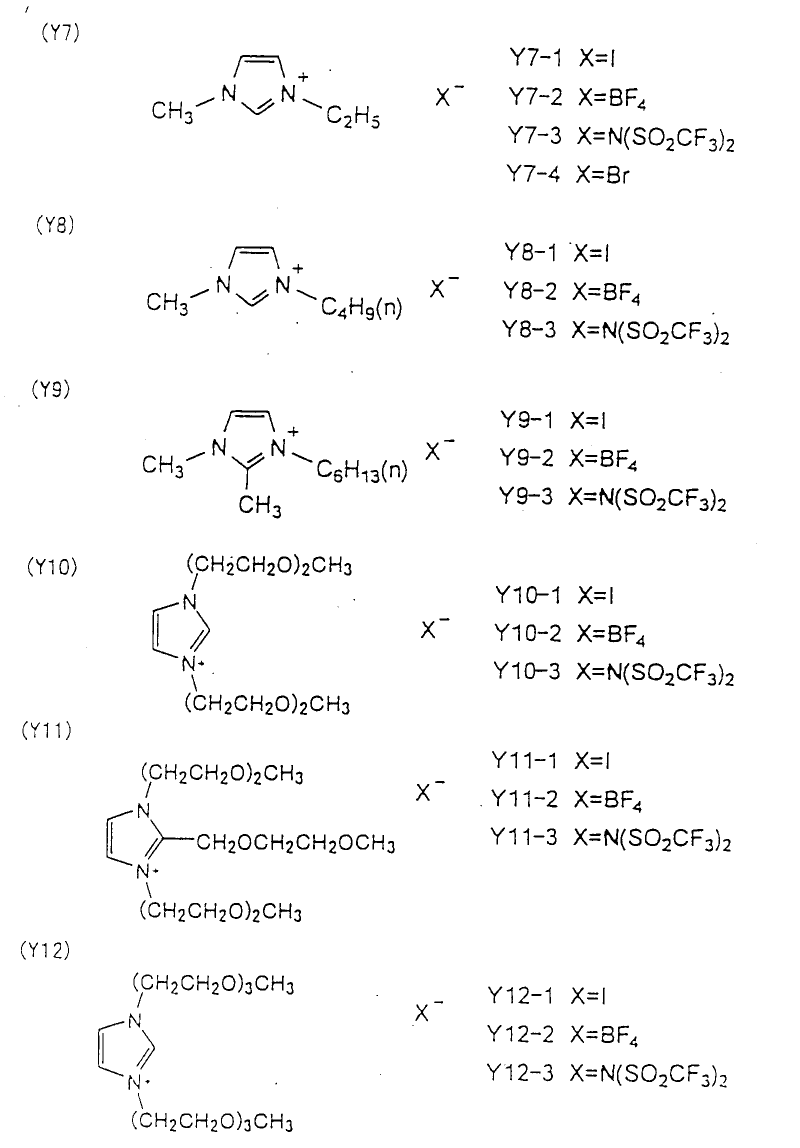

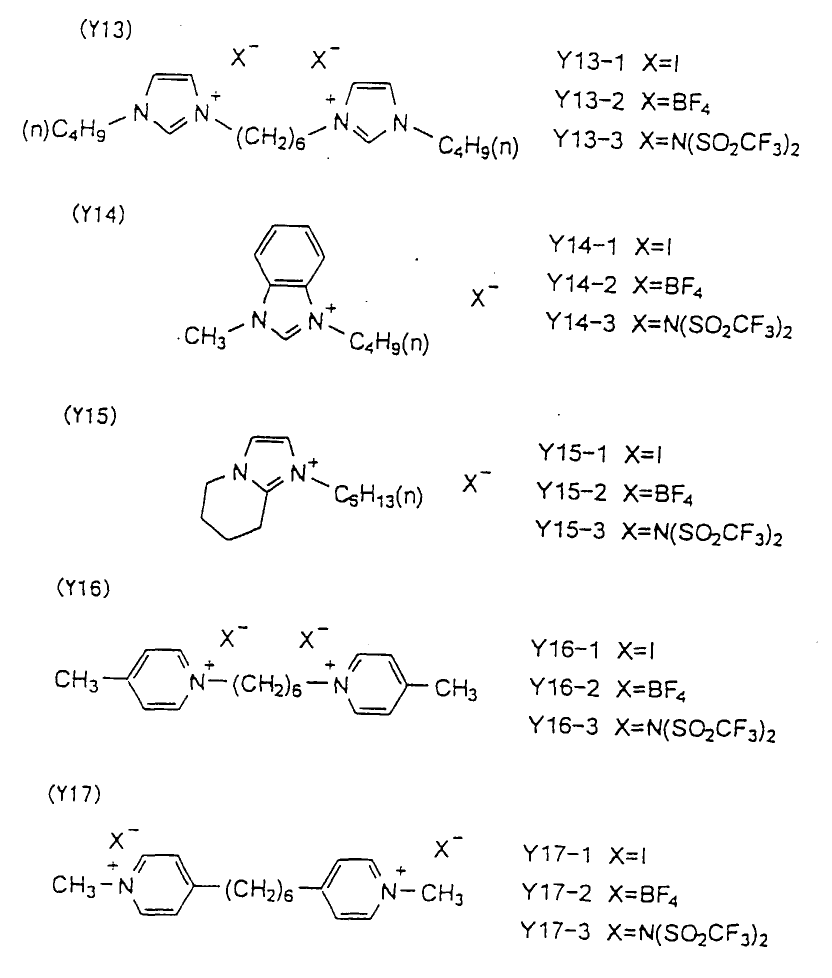

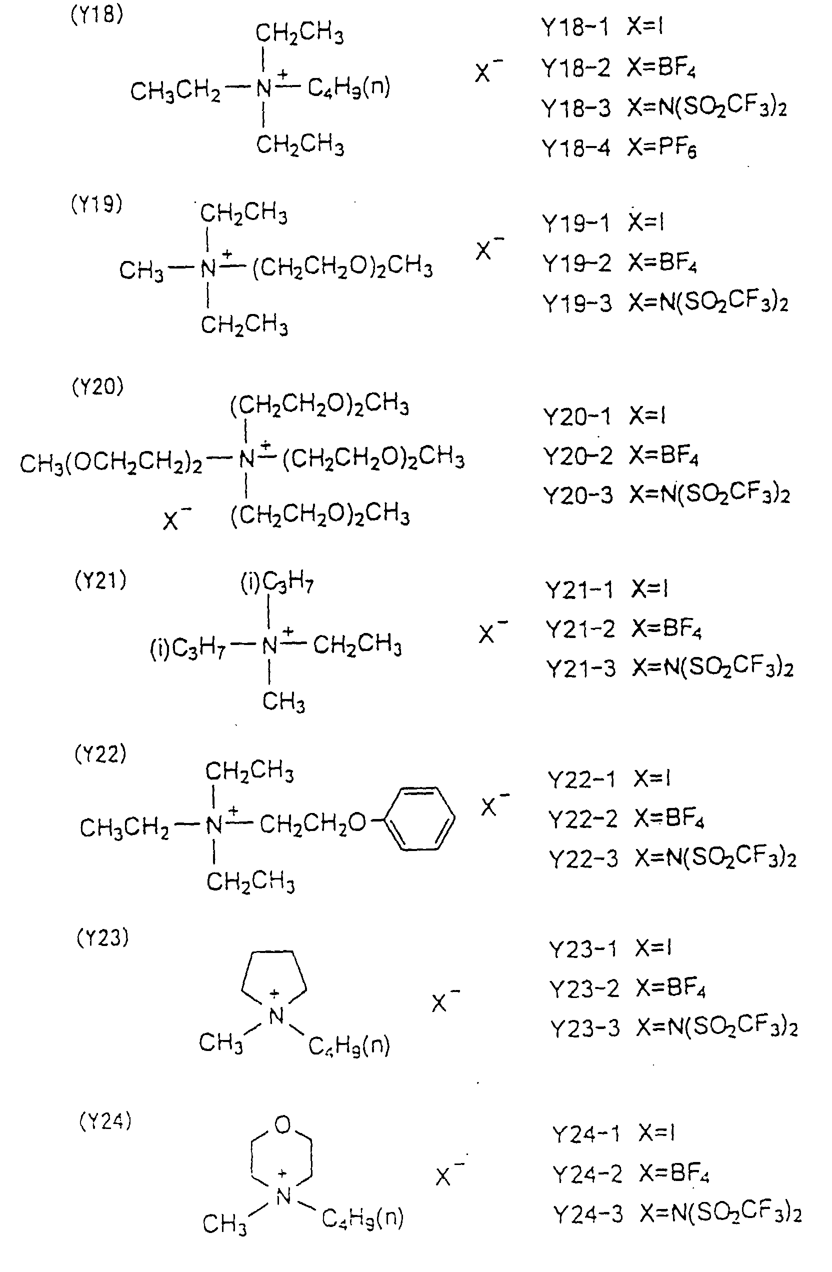

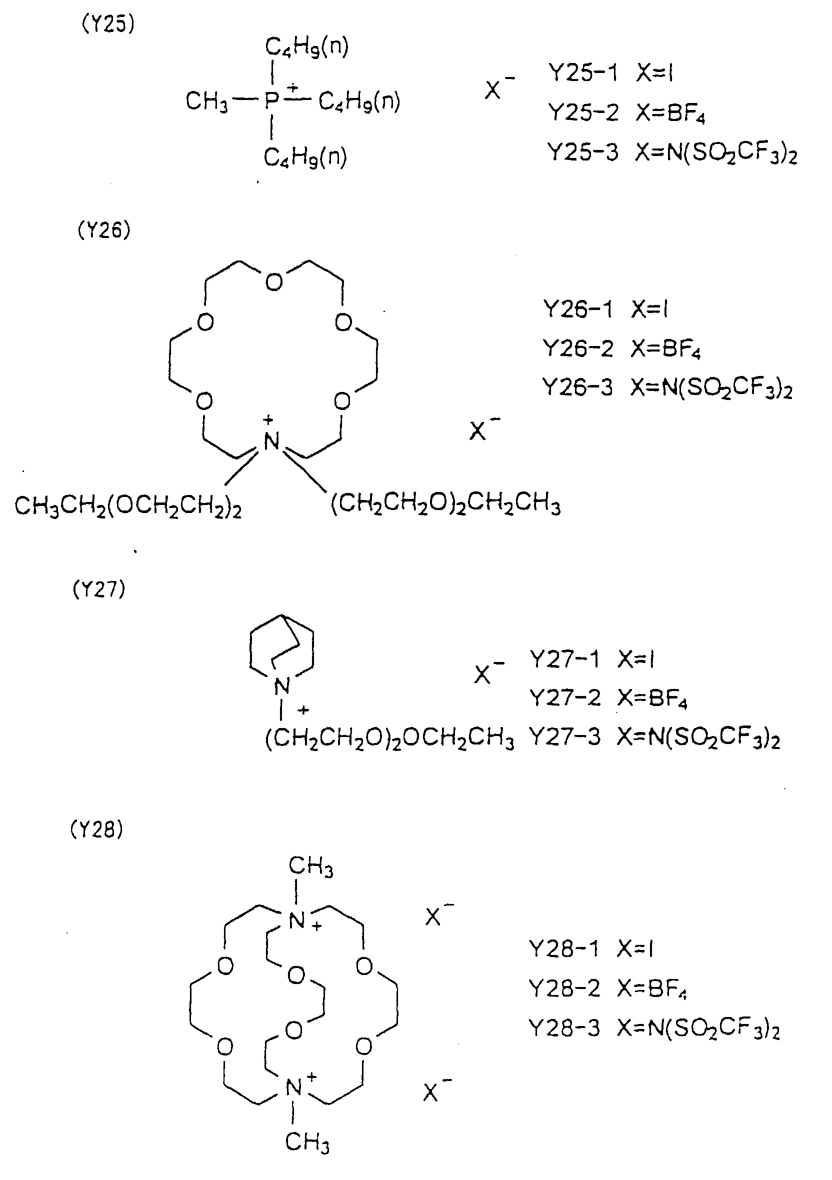

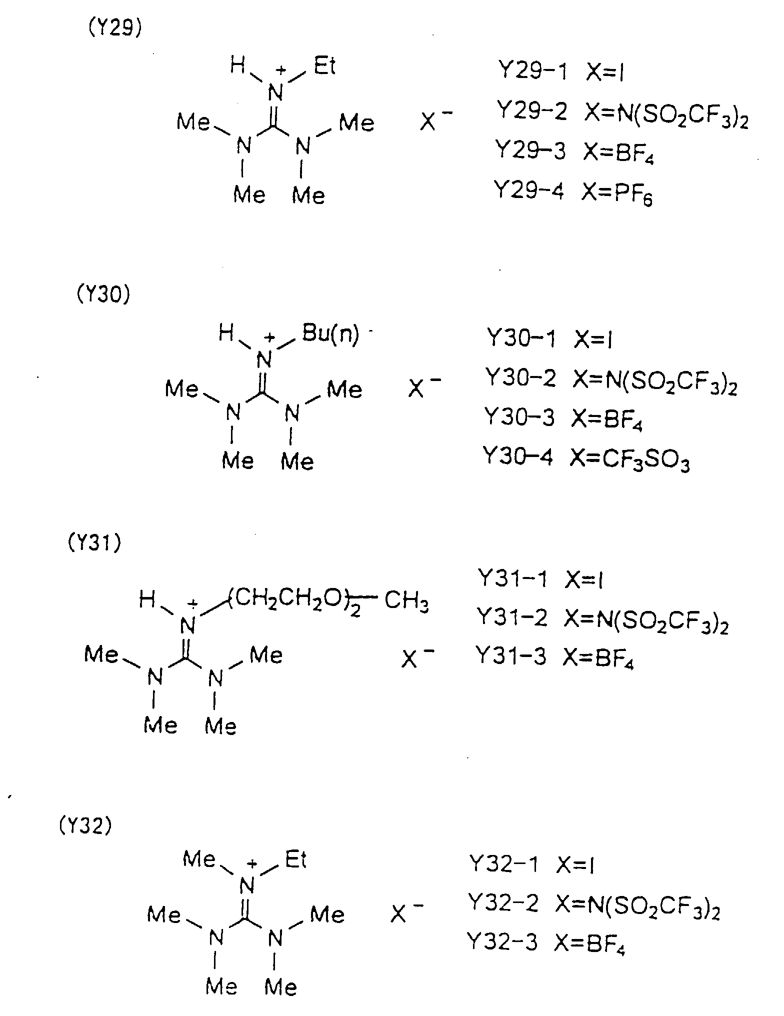

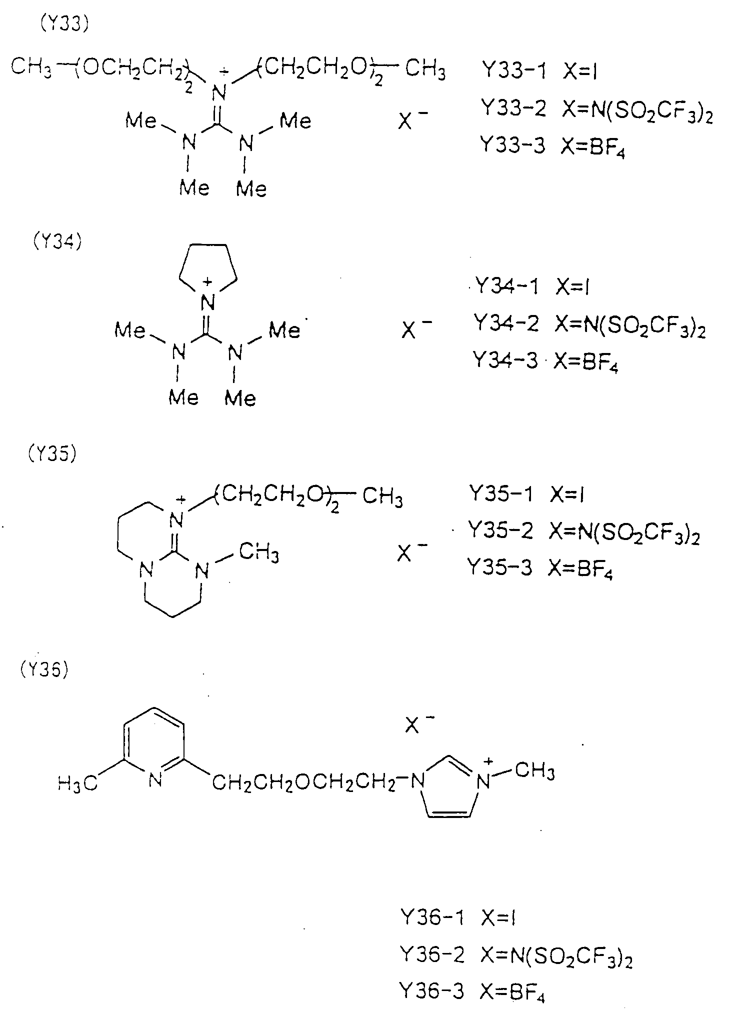

It is preferred for the solvent, if used to dissolve the molten salt electrolyte, to have a low viscosity and a high dielectric constant thereby to manifest excellent ion conductivity. To have a low viscosity leads to an improvement in ion mobility. To have a high dielectric constant brings about an increase in effective carrier concentration. Solvents suitable from this viewpoint include carbonate compounds, such as ethylene carbonate and propylene carbonate; heterocyclic compounds, such as 3-methyl-2-oxazolidinone; ether compounds, such as dioxane and diethyl ether; acyclic ethers, such as ethylene glycol dialkyl ethers, propylene glycol dialkyl ethers, polyethylene glycol dialkyl ethers, and polypropylene glycol dialkyl ethers; alcohols, such as methanol, ethanol, ethylene glycol monoalkyl ethers, propylene glycol monoalkyl ethers, polyethylene glycol monoalkyl ethers, and polypropylene glycol monoalkyl ethers; polyhydric alcohols, such as ethylene glycol, propylene glycol, polyethylene glycol, polypropylene glycol, and glycerin; nitrile compounds, such as acetonitrile, glutaronitrile, methoxyacetonitrile, propionitrile, and benzonitrile; and aprotic polar solvents, such as dimethyl sulfoxide(DMSO) and sulfolane. These solvents can be used either individually or as a mixture of two or more thereof.

The electrolyte composition can contain a metal iodide, such as LiI, NaI, KI, CsI or CaI₂, a metal bromide, such as LiBr, NaBr, KBr, CsBr or CaBr₂, a bromine salt of a quaternary ammonium compound, such as a tetraalkylammonium bromide or pyridinium bromide, a metal complex, such as a ferrocyananate-ferricyanate system or a ferrocene-ferricinium ion system, a sulfur compound, such as poly(sodium sulfite) or an alkylthiol-alkyl disulfide, a viologen dye, hydroquinone-quinone, and the like.

The electrolyte composition can further contain a basic compound, such as ter-butylpyridine, 2-picoline, and 2,6-lutidine, as disclosed in *J. Am. Ceram. Soc*., vol. 80, No. 12, pp. 3157-3171 (1997). A preferred concentration of the basic compound is 0.05 to 2 M.

The water content of the charge transporting layer is preferably 10,000 ppm or less, still preferably 2,000 ppm or less, particularly preferably 100 ppm or less.

The molten salt electrolyte can be used as mixed with a minor proportion of an electrolytic solution comprising a redox pair dissolved in an organic solvent. The molten salt electrolyte may be galled (solidified) by a gelling agent or used in combination with a gel electrolyte. The molten salt electrolyte may be provided between a solid electrolyte and a semiconductor porous electrode layer.

There are two conceivable methods of forming a charge transporting layer. One comprises adhering a counter electrode to the dye-sensitized semiconductor layer and penetrating a liquid charge transporting material into the gap therebetween. The other comprises forming a charge transporting lever on the dye-sensitized semiconductor layer and then providing a counter electrode thereon. The former method can be effected by an ambient pressure process which makes use of capillarity by, for example, soaking or a vacuum process in which a gas phase is displaced with a liquid phase under reduced pressure.

In the latter method, the charge transporting layer can be formed on the particulate semiconductor layer by immersion, roll coating, dip coating, air knife coating, extrusion coating, slide hopper coating, wire bar coating, spin coating, spraying, casting, and various printing methods, and a counter electrode is provided thereon while the layer is wet, and the edges call for a leakproof measure. A gel electrolyte layer may be formed by applying a wet electrolyte and solidifying the liquid by, for example, polymerization. In this case, the solidified gel electrolyte is dried and fixed before a counter electrode is provided.

In case where iodine, etc. is incorporated into the electrolyte to make a redox pair, it can be added directly to the above-described electrolytic solution, or an electrolyte layer formed on a substrate is put in a closed container together with iodine, etc. to have iodine diffused therein. Iodine, etc. can also be incorporated into the electrolyte layer by application or vacuum deposition onto the counter electrode hereinafter described, which is used in assembly of a photo-electrochemical cell.

In a photo-electrochemical cell using the photoelectric conversion device, the counter electrode functions as a positive electrode. The counter electrode usually comprises a substrate having thereon a conductive layer, such as the one used for the semiconductor electrode (work electrode), but the substrate is not always required as far as sufficient strength or tight seal is secured. Conductive materials of choice for the counter electrode include metals (e.g., platinum, gold, silver, copper, aluminum, rhodium, and indium), carbon, and conductive metal oxides (e.g., indium-tin complex oxide and fluorine-doped tin oxide). Suitable counter electrodes include a glass or plastic substrate having a metal or a conductive oxide deposited thereon and a thin metal film. While not limiting, the counter electrode preferably has a thickness of 3 nm to 10 µm. In particular, a metallic counter electrode preferably has a thickness of 5 µm or smaller, particularly 5 nm to 3 µm.

At least one of the conductive support of the work electrode and the counter electrode must be substantially transparent so that incident light can reach the photosensitive layer. It is preferred for the photo-electrochemical cell of the invention that the conductive support of the work electrode be transparent so that light may be incident upon this side. In this case, it is a preferred embodiment that the counter electrode has light reflecting properties.

As explained with respect to formation of the charge transporting layer, the counter electrode is provided either on the charge transporting layer or directly on the particulate semiconductor-containing layer. In either case, the counter electrode can be provided by coating, laminating, vacuum evaporation, press bonding, or the like method as selected appropriately according to the kind of the counter electrode or the kind of the charge transporting layer. For example, a substrate having a conductive layer of the above-described conductive material formed by coating, vacuum evaporation or CVD can be stuck on the charge transporting layer or the particulate semiconductor-containing layer. Where the charge transporting layer is solid, the above-described conductive material can be applied thereon by coating, plating, PVD, CVD, or a like technique.

If necessary, additional functional layers, such as a protective layer and an antireflection layer, can be formed on the conductive support of the work electrode and/or the counter electrode. Where a plurality of additional layers having the respective functions are to be provided, while they can be formed either simultaneously or successively, simultaneous coating is preferred for productivity. Simultaneous coating is conveniently carried out by a slide hopper method or extrusion coating in view of productivity and uniformity of the film formed. Depending on the material, these functional layers may be provided by vacuum evaporation or press bonding.

The photo-electrochemical cell of the invention preferably has its sides sealed with a polymer, an adhesive, etc. to prevent deterioration or volatilization of the volatile matter contained therein.

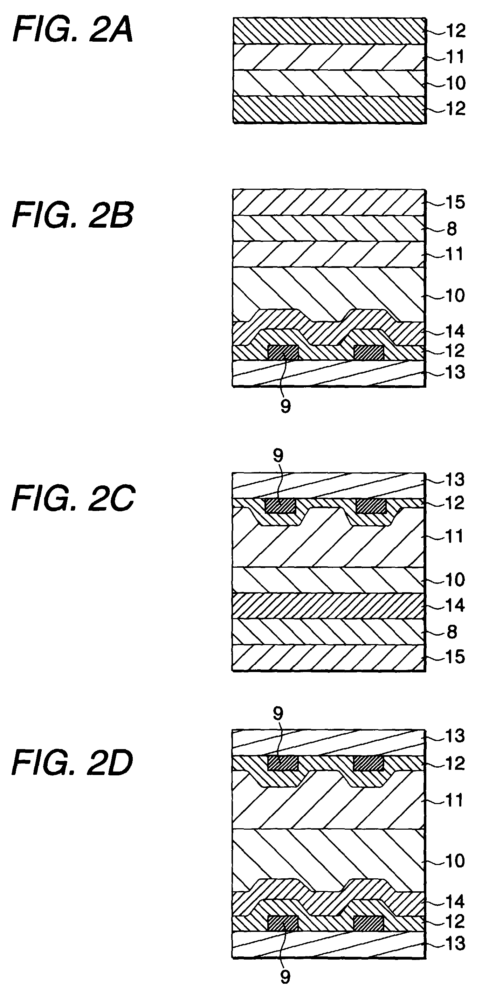

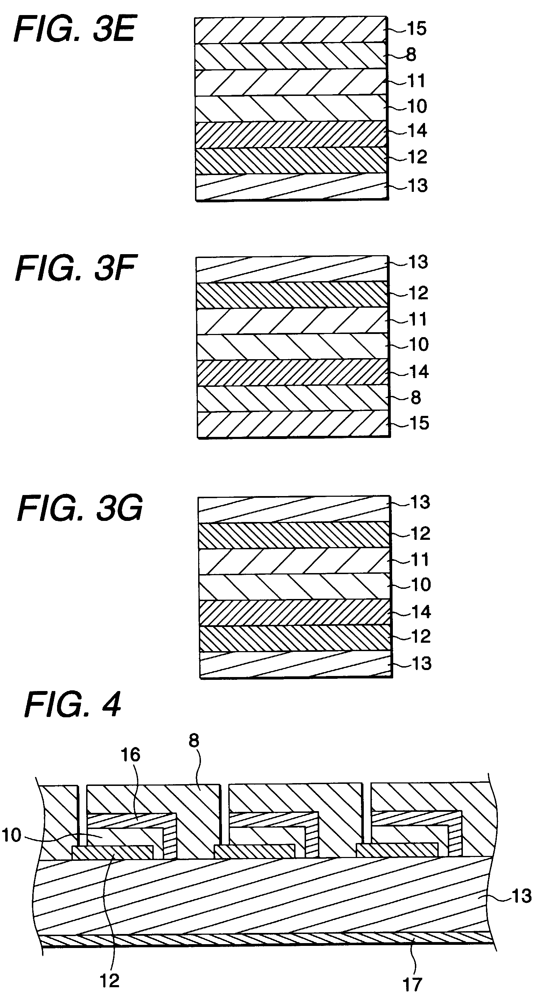

The cell structure and the module structure of the photo-electrochemical cell, especially a dye-sensitized solar cell, to which the photoelectric conversion device of the invention is applied are then described. While a dye-sensitized solar cell basically has the same structure as the above-described photoelectric conversion device and photo-electrochemical cell, a variety of forms can be taken in conformity with the end use as shown in Figs. 2 and 3. Conceivable forms are roughly divided into two types; structures which receive light from both sides (Figs. 2A, 2D and 3G) and those which receive light from one side (Figs. 2B, 2C, 3E, and 3F).

Fig. 2A is a structure made up of a pair of transparent conductive layers 12 having sandwiched therebetween a dye-sensitized (zinc oxide + tin oxide) layer 10 as a semiconductor-containing layer and a charge transporting layer 11. Fig. 2B is a structure having, in the order described, a transparent substrate 13, a metal lead 9 (partially provided), a transparent conductive layer 12, an undercoat 14, a dye-sensitized (zinc oxide + tin oxide) layer 10, a charge transporting layer 11, a metal lever 8, and a supporting substrate 15. Fig. 2C shows a structure having, in the order described, a supporting substrate 15, a metal layer 8, an undercoat 14, a dye-sensitized (zinc oxide + tin oxide) layer 10, a charge transporting layer 11, a transparent conductive layer 12, and a transparent substrate 13 partially having thereon a metal lead 9 with the metal lead side thereof inside. Fig. 2D is a structure made up of a pair of transparent substrates 13 each having a metal lead 9 (partially provided) and a transparent conductive layer 12 with the transparent conductive layer 12 inside, having sandwiched therebetween an undercoat 14, a dye-sensitized (zinc oxide + tin oxide) layer 10, and a charge transporting layer 11. Fig. 3E depicts a structure having, in the order described, a transparent substrate 13, a transparent conductive layer 12, an undercoat 14, a dye-sensitized (zinc oxide + tin oxide) layer 10, a charge transporting layer 11, a metal layer 8, and a supporting substrate 15. Fig. 3F illustrates a structure having, in the order described, a supporting substrate 15, a metal layer 8, an undercoat 14, a dye-sensitized (zinc oxide + tin oxide) layer 10, a charge transporting layer 11, a transparent conductive layer 12, and a transparent substrate 13. Fig. 3G shows a structure composed of a pair of transparent substrates 13 each having on the inner side thereof a transparent conductive layer 12, having sandwiched therebetween an undercoat 14, a dye-sensitized (zinc oxide + tin oxide) layer 10, and a charge transporting layer 11.

The module of the dye-sensitized solar cell basically has the same structure as conventional solar cell modules. It generally comprises cells built up on a metallic, ceramic or like supporting substrate and covered with a filling resin or protective glass so that light can enter on the side opposite to the supporting substrate. Where the supporting substrate, on which the cells are provided, is made of a transparent material such as tempered glass, the cells can take in light from the side of the transparent supporting substrate. The module structure includes a superstraight type, a substraight type or potting type or a substrate-integrated type used in amorphous silicon solar cells. A suitable module structure can be chosen appropriately according to the end use or the place of use, i.e., the environment in which it is to be used.

Fig. 4 presents an example of a substrate-integrated type module of the device according to the invention. The module structure shown comprises cells formed on a transparent substrate 13 which has on one side thereof a transparent conductive layer 12, a dye-sensitized (zinc oxide + tin oxide) layer 10, a charge transporting layer 16 containing a molten salt electrolyte, and a metal layer 8 and, on the other side, an antireflection layer 17. It is preferred to increase the area ratio (the ratio of the area seen from the transparent substrate 13, the light incident side) of the dye-sensitized (zinc oxide + tin oxide) layer 10, which is a photosensitive area, to increase the utilization efficiency of incident light.

A superstraight or substraight type module typically comprises a pair of supporting substrates one or both of which are transparent and have been subjected to an antireflection surface treatment, having cells interposed therebetween at regular intervals, the cells being connected to each other with a metal lead, flexible wiring, etc. A current collecting electrode is disposed at the outer edge to take out the generated power. In order to protect the cells and to increase the current collection efficiency, various plastic materials, such as ethylene-vinyl acetate copolymer (EVA), selected according to the purpose can be provided between the substrates and the cells in the form of a film or a filling resin. Where the module is for use in places free from shocks so that there is no need to cover the surface with a rigid material, the surface protective layer may be of a transparent plastic film, or the above-mentioned filling and/or a sealing material is hardened to serve as a protector which can take the place of the substrate on that side. To secure tight seal of the inside and rigidity of the module, the peripheries of the supporting substrates are fixed in a metal frame, and the gap between the substrates and the frame is sealed with a sealing compound.

A solar cell could be constituted even on a curved surface by using flexible materials for the cells themselves, substrates, filling materials and sealing compounds. Thus, solar cells having various forms or functions can be produced in conformity with the end use or the environment of use.

On an industrial scale, solar cell modules of superstraight type are manufactured by, for example, successively providing a front substrate, fed from a substrate feeder and carried on a belt conveyer, etc., with cells together with a sealing compound, leads for cell connection, back side sealing compound, and the like, putting thereon a back substrate or a back cover, and setting a frame around the peripheries. Those of substraight type are manufactured by, for example, successively providing a supporting substrate, fed from a substrate feeder and carried on a belt conveyer, etc., with cells together with leads for cell connection, a sealing compound, and the like, putting a front cover thereon, and setting a frame around the peripheries.

Modules of substrate-integrated type shown in Fig. 4 are produced by successively providing a supporting substrate with a transparent electrode layer, a photosensitive layer, a charge transporting layer, a back electrode layer, etc. to build up three-dimensional structures at given intervals by known semiconductor processing techniques, such as selective plating, selective etching, CVD and PVD, or by pattern coating, or by mechanical processing techniques involving the step of forming a layer by coating in a band form, followed by patterning by laser machining, plasma CVM (see *Solar Energy* *Materials and Solar Cells*, vol. 48, pp. 373-381) or a mechanical means, such as grinding.

The sealing compound to be used in the module manufacture is selected from various materials, for example, liquid EVA (ethylene-vinyl acetate), a mixture of vinylidene fluoride copolymer and an acrylic resin, and an EVA (ethylene-vinyl acetate) film, in accordance with the purposes, such as improvement on weatherability, electrical insulation, improvement on light collection efficiency, protection of cells (improvement on impact resistance), and the like. The sealing compound is applied on the cells by an appropriate method fit for the physical properties of the compound. For example, a sealing material of film form is applied onto the cells by pressing with a roller or vacuum packaging, followed by heat sealing. A liquid or pasty sealing compound can be applied by roll coating, bar coating, spraying, screen printing, or a like method. A transparent filler may be added to the sealing compound to enhance the strength or to increase light transmission. Weatherable and moistureproof resins are convenient for sealing the gap between the periphery of the module and the frame.

Where a flexible substrate of PET, PEN, etc. is used, a highly productive production process is constituted by unrolling the substrate from a rollstock, building up cells thereon, and applying a sealing layer continuously in the manner described above.

In order to increase power generation efficiency of the module, the light-receiving side of the substrate (generally tempered glass) is subjected to an antireflection surface treatment, such as laminating or coating with an antireflection coat. Further, incident light utilization efficiency can be increased by grooving or texturing the cell surface. It is important for obtaining increased power generation efficiency not only that light be took in the inside of the module with little loss but that the light having passed through the photosensitive layer and reached the opposite substrate be reflected and returned to the photosensitive layer. This is achieved by a method comprising mirror polishing the surface of the back substrate and applying Ag, Al, etc. by vacuum evaporation or plating, a method comprising providing the back side of the cell with an alloy layer of Al-Mg, Al-Ti, etc. as a reflecting layer, or a method comprising annealing to have the back side textured.

It is also important for increasing the power generation efficiency to minimize the resistance of intercellular connections thereby to suppress internal voltage drop. The cells are usually connected by wire bonding or with a conductive flexible sheet. In addition, a conductive adhesive tape or a conductive adhesive can be used for achieving both fixing of the cells and electrical connection among the cells, or a conductive hot-melt adhesive can be patternwise applied to desired sites.

Solar cells using a flexible substrate such as a polymer film are produced by successively forming cells on the substrate, being unrolled and transferred, in the manner described above, cutting to size, and sealing the periphery with a flexible and moistureproof material. A module structure called "SCAF" (see S*olar Energy Materials and Solar Cells*, vol. 48, pp. 383-391) is also applicable. Solar cells having a flexible substrate can be used as adhered to curved glass.

### EXAMPLE

The present invention will now be illustrated in greater detail with reference to the following Examples. Unless otherwise noted, all the percents are by weight.

### 1) Preparation of titanium dioxide dispersion (for comparison)

A titanium dioxide dispersion having a concentration of 8% was prepared in accordance with the method using nitric acid which is reported in Barbe, et al, *J. Am. Ceram. Soc.*, vol. 80, No. 12 p. 3157 (1997), except that the autoclaving was conducted at 250°C for 16 hours. The average particle size of the dispersed titanium dioxide particles was about 15 nm as measured from the X-ray diffraction line width of (101) reflection. The coefficient of variation in particle size was 43%. To the dispersion was added polyethylene glycol (molecular weight: 500,000, available from Wako Pure Chemical Ind., Ltd.) in an amount of 30% based on the titanium dioxide to prepare a titanium dioxide dispersion (designated dispersion 1).

### 2) Preparation of zinc oxide/tin oxide mixed dispersion

A dispersion containing zinc oxide/tin oxide mixed particles was prepared in the same manner as disclosed in K. Tennakone, *Chem. Commun*., pp.15-16 (1999). That is, 0.1 ml of acetic acid and 0.3 g of zinc oxide particles having a grain size of about 2 µm which were prepared by pyrolysis of zinc oxalate were added to 1.5 ml of a 15% aqueous dispersion of colloidal tin dioxide particles having a grain size of about 0.015 µm. The mixture was mixed in an agate mortar, and 20 ml of methanol was added thereto, followed by 30 minutes ultrasonic dispersion to prepare a suspension (designated dispersion 2). The weight ratio of zinc oxide to tin oxide contained in dispersion 2 was 57:43.

Dispersion 3 was prepared in the same manner as for dispersion 2, except that tin dioxide was not used.

Dispersion 4 was prepared in the same manner as for dispersion 2, except for changing the zinc oxide to tin oxide weight ratio to 30:70.

Dispersion 5 was prepared in the same manner as for dispersion 2, except for changing the zinc oxide to tin oxide weight ratio to 53:47.

Dispersion 6 was prepared in the same manner as for dispersion 2, except for changing the zinc oxide to tin oxide weight ratio to 70:30.

Dispersion 7 was prepared in the same manner as for dispersion 2, except that zinc oxide was not used.

### 3) Preparation of dye-sensitized semiconductor electrode

A semiconductor porous electrode layer comprising metal oxide particles was formed on the conductive layer side of a transparent conductive glass substrate having an fluorine-doped tin oxide coat (available from Nippon Sheet Glass Co., Ltd.; surface resistivity: about 10 Ω/square) as follows.

Dispersion 1 was applied to the substrate to a coating thickness of 100 µm with a doctor blade, dried at 25°C for 30 minutes, and burned in an electric muffle furnace (Model FP-32, manufactured by Yamato Kagaku) at 500°C for 35 minutes. The coating weight and thickness of the titanium dioxide layer were 13.5 g/m² and 9 µm, respectively. The resulting electrode was designated electrode 1.

Dispersion 2 was sprayed to the substrate heated to 150°C, and burned in air at 500°C for 35 minutes to form a 9 µm thick porous semiconductor layer. The resulting electrode was designated electrode 2.

Electrodes 3 to 7 having a 9 µm thick semiconductor porous film were prepared in the same manner as for electrode 2, except for using dispersions 3 to 7, respectively.

After cooling, each of electrodes 1 to 7 was immersed in an ethanolic solution of 3 x 10⁻⁴ mol/l of dye R-1 at a refluxing temperature for 3 minutes. The dyed semiconductor layer was washed with acetonitrile and dried spontaneously in a dark place. The amount of the dye adsorbed was in the range of from about 0.9 to 1.1 x 10⁻³ mol per m² of the semiconductor electrode.

### 4) Preparation of photo-electrochemical cell

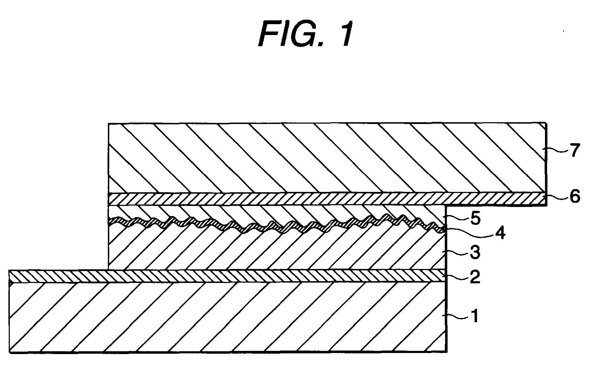

Electrode 1 cut to 2 cm by 2 cm and a platinum-deposited glass substrate of the same size were brought into contact with the electrode layer and the platinum-deposit layer facing each other. An electrolyte consisting of 1.0 g of Y8-1, 8.8 g of biscyanoethyl ether, and 0.2 g of iodine was introduced into the gap between the two glass substrates by making use of capillarity to prepare a photo-electrochemical cell (designated cell C-1) having the structure shown in Fig. 1, which is composed of a conductive support (glass 1 with a conductive layer 2), a semiconductor electrode layer 3, a dye layer 4, an electrolyte layer 5, a platinum layer 6, and a glass substrate 7 in this order.

Photo-electrochemical cell C-2 was prepared in the same manner as for cell C-1, except for using a molten salt electrolyte consisting of 7.0 g of Y8-1, 2.8 g of Y7-2, and 0.2 g of iodine.

Photo-electrochemical cell C-3 was prepared in the same manner as for cell C-1, except for replacing electrode 1 with electrode 2.

Photo-electrochemical cell C-4 was prepared in the same manner as for cell C-3, except for using the same molten salt electrolyte as used in cell C-2.

Photo-electrochemical cells C-5 to -9 were prepared in the same manner as for cell C-4, except for using electrodes 3 to 7, respectively.

Photo-electrochemical cells C-10 to -15 were prepared in the same manner as for cell C-7, except for changing the composition of the molten salt electrolyte.

The constitution of the resulting photo-electrochemical cells are summarized in Table 1 below.

**TABLE 1**

| Cell No. | Semiconductor Electrode | Electrolyte Composition |
|---|---|---|
| C-1 | titanium dioxide | Y8-1: 1.0 g |
| | | biscyanoethyl ether: 8.8 g |
| | | iodine: 0.2 g |
| C-2 | " | Y8-1: 7.0 g |
| | | Y7-2: 2.8 g |
| | | iodine: 0.2 g |
| C-3 | zinc oxide/tin oxide (57/43) | Y8-1: 1.0 g |
| | | biscyanoethyl ether: 8.8 g |
| | | iodine: 0.2 g |
| C-4 | " | Y8-1: 7.0 g |
| | | Y7-2: 2.8 g |
| | | iodine: 0.2 g |
| C-5 | zinc oxide | " |
| C-6 | zinc oxide/tin oxide (30/70) | " |
| C-7 | zinc oxide/tin oxide (53/47) | " |
| C-8 | zinc oxide/tin oxide (70/30) | " |
| C-9 | tin oxide | " |
| C-10 | zinc oxide/tin oxide (53/47) | Y8-1: 7.0 g |
| | | Y7-3: 2.8 g |
| | | iodine: 0.2 g |
| C-11 | " | Y10-1: 7.0 g |
| | | Y7-2: 2.8 g |
| | | iodine: 0.2 g |
| C-12 | " | Y12-1: 7.0 g |
| | | Y7-2: 2.8 g |
| | | iodine: 0.2 g |
| C-13 | " | Y10-1: 7.0 g |
| | | Y10-2: 2.8 g |
| | | iodine: 0.2 g |
| C-14 | " | Y10-1: 7.0 g |
| | | Y36-3: 2.8 g |
| | | iodine: 0.2 g |
| C-15 | " | Y8-1: 5.7 g |
| | | Y7-2: 2.6 g |
| | | t-butylpyridine: 1.6 g |
| | | iodine: 0.2 g |

### 5) Measurement of photoelectric conversion efficiency

The conductive glass and the platinum-deposited glass were connected by means of alligator clips, and the cell was irradiated with pseudo-sunlight having an intensity of 100 mW/cm² which was created by cutting light from a 500 W xenon lamp (produced by Ushio Inc.) through a spectral filter (AM1.5 Filter available from Oriel). The temperature of the cell was kept constant at 50°C or 25°C while being irradiated. The generated electricity was recorded with a Keithley electrometer (Model SMU238) to obtain an open circuit voltage (V_{OC}), a short circuit current density (J_{SC}), a fill factor (FF), and a conversion efficiency (η).

Further, the cells were stored at 80°C for 7 days and then tested in the same manner as described above (cell temperature: 50°C) to evaluate the durability. The results obtained are shown in Table 2 below.

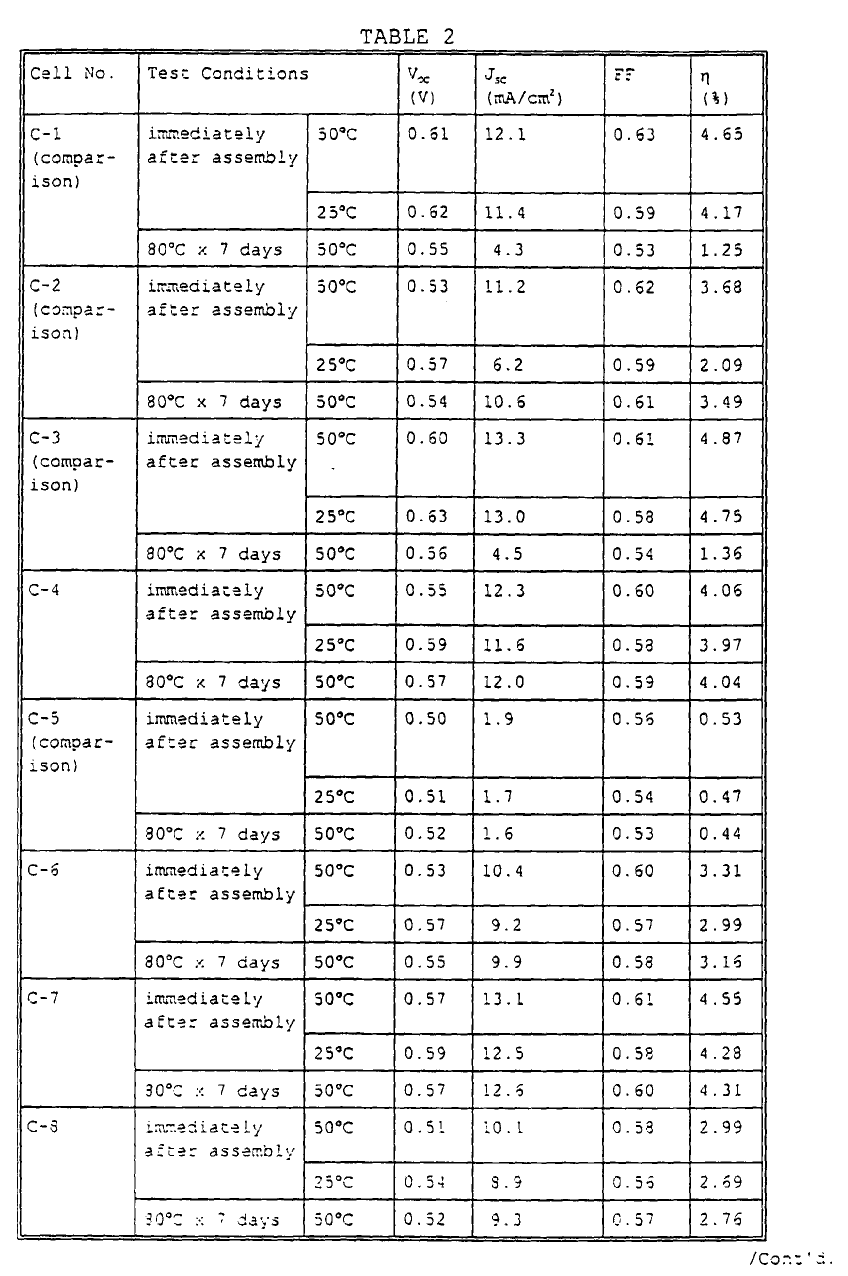

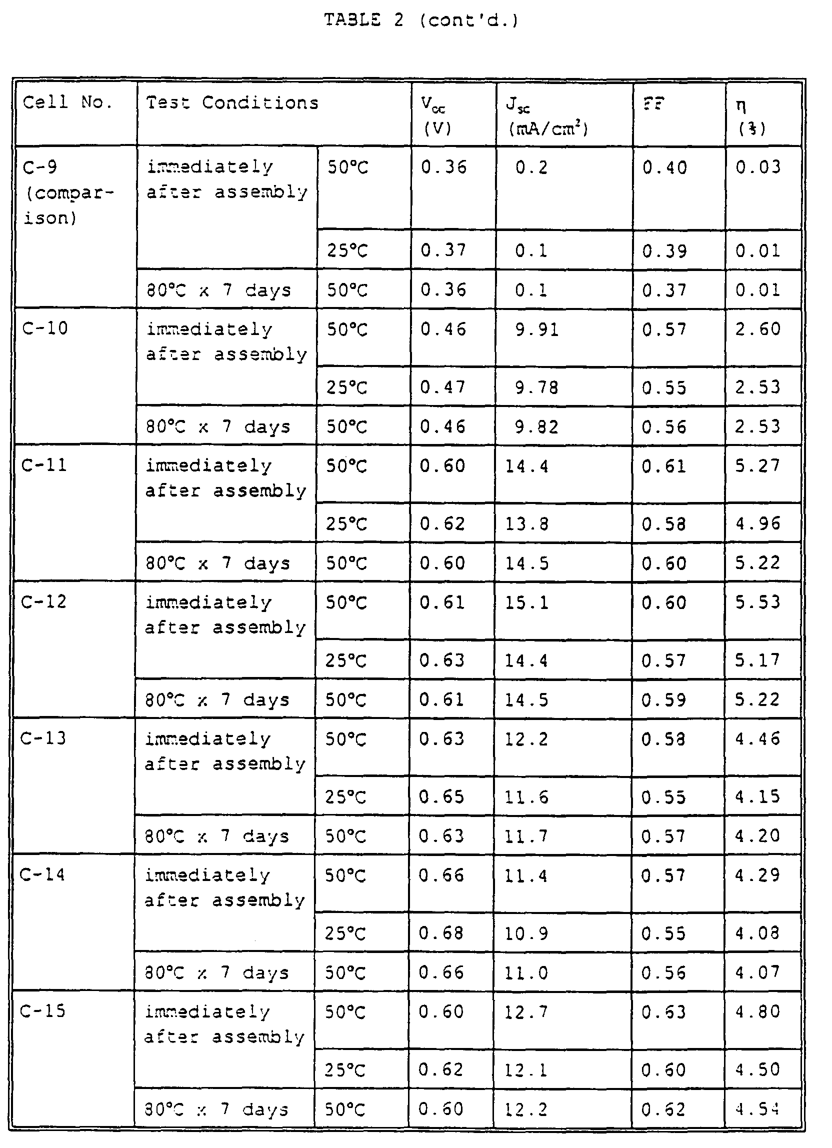

The results in Table 2 reveal the following. Although photo-electrochemical cell C-1 comprising a combination of the comparative titanium dioxide electrode and a solvent type electrolyte exhibits relatively satisfactory performance immediately after assembly at 50°C, and the reduction in performance at 25°C is suppressed, it undergoes remarkable deterioration when stored at 80°C. While cell C-2 comprising a molten salt electrolyte in place of the solvent type one has improved durability, it exhibits reduced performance immediately after assembly and undergoes considerable reduction of performance when the working temperature is lowered to 25°C.

On the other hand, cells comprising a zinc oxide/tin oxide mixed electrode in combination with the durable molten salt electrolyte exhibit excellent performance immediately after assembly and hardly reduce the performance even when the working temperature was decreased to 25°C. These characteristics are surprising effects not observed with the individual use of zinc oxide or tin oxide. Excellent photo-electrochemical cells having both durability and high conversion efficiency cannot be obtained without using the combination of the semiconductor electrode of the present invention and a molten salt electrolyte.

The present invention provides a dye-sensitized photoelectric conversion device and a photo-electrochemical cell which have a high short circuit current, a high efficiency, and excellent durability.

## Claims

1. A photoelectric conversion device comprising at least:
a photosensitive layer comprising semiconductor particles; and
a charge transporting layer,
wherein the semiconductor particles comprise zinc oxide and tin oxide, and the charge transporting layer comprises at least 50% by weight of a molten salt electrolyte.

2. The photoelectric conversion device according to claim 1, wherein said semiconductor particles are produced by a process comprising:
mixing zinc oxide particles and tin oxide particles to form a mixture; and
burning the mixture.

3. The photoelectric conversion device according to claim 1, wherein said semiconductor particles are produced by a process comprising:
mixing zinc oxide particles and tin chloride to form a mixture; and
burning the mixture.

4. The photoelectric conversion device according to claim 1, 2, or 3, wherein said tin oxide is tin dioxide.

5. The photoelectric conversion device according to claim 1, 2, 3, or 4, wherein said molten salt electrolyte comprises at least one compound selected from the group consisting of compounds represented by formula (Y-a), compounds represented by formula (Y-b), compounds represented by formula (Y-c): 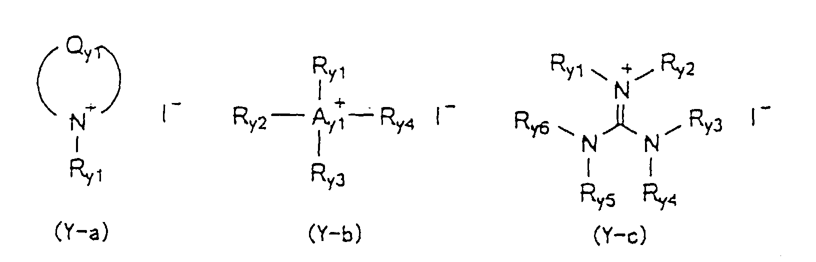 wherein Q_{y1} represents an atomic group capable of forming a 5- or 6-membered aromatic ring cation together with the nitrogen atom; A_{y1} represents a nitrogen atom or a phosphorus atom; R_{y1}, R_{y2}, R_{y3}, R_{y4}, R_{y5}, and R_{y6} each represent a substituted or unsubstituted alkyl group or a substituted or unsubstituted alkenyl group; two or more of R_{y1}, R_{y2}, R_{y3}, and R_{y4} in formula (Y-b) may be connected to each other to form a non-aromatic ring containing A_{y1}, and two or more of R_{y1}, R_{y2}, R_{y3}, R_{y4}, R_{y5}, and R_{y6} in formula (Y-c) may be connected to each other to form a cyclic structure; and the compound of formula (Y-a), (Y-b) or (Y-c) may have a polymerized form by linking through any of Q_{y1}, R_{y1}, R_{y2}, R_{y3}, R_{y4}, R_{y5}, and R_{y6}.

6. The photoelectric conversion device according to any one of claims 1 to 5, wherein said semiconductor particles have a dye adsorbed thereon.

7. A photo-electrochemical cell comprising the photoelectric conversion device according to any one of claims 1 to 6.
